Europäisches Patentamt

European Patent Office

Office européen des brevets

(19)

(11) **EP 0 615 669 B1**

(12) **EUROPÄISCHE PATENTSCHRIFT**

(45) Veröffentlichungstag und Bekanntmachung des Hinweises auf die Patenterteilung:
**22.09.1999 Patentblatt 1999/38**

(21) Anmeldenummer: **93909641.8**

(22) Anmeldetag: **14.10.1992**

(51) Int Cl.$^6$: **H03F 3/72**, G01R 19/165

(86) Internationale Anmeldenummer:
**PCT/EP92/02363**

(87) Internationale Veröffentlichungsnummer:
**WO 93/11607 (10.06.1993 Gazette 1993/14)**

(54) **VERFAHREN UND SCHALTUNG ZUR MESSUNG VON TEILCHENSTRÖMEN**

PROCESS AND CIRCUIT FOR MEASURING PARTICLE FLUXES

PROCEDE ET CIRCUIT POUR LA MESURE DE COURANTS DE PARTICULES

(84) Benannte Vertragsstaaten:
**CH DE FR GB IT LI**

(30) Priorität: **05.12.1991 DE 4140112**

(43) Veröffentlichungstag der Anmeldung:
**21.09.1994 Patentblatt 1994/38**

(73) Patentinhaber: **Balzers und Leybold Deutschland Holding Aktiengesellschaft**
**63450 Hanau (DE)**

(72) Erfinder: **ROLFF, Norbert**
**D-5014 Horrem (DE)**

(74) Vertreter: **Leineweber, Jürgen, Dipl.-Phys.**
**Aggerstrasse 24**
**50859 Köln (DE)**

(56) Entgegenhaltungen:
**EP-A- 0 102 177**  **EP-A- 0 410 399**
**US-A- 3 541 462**  **US-A- 3 551 839**
**US-A- 3 671 931**

**Beschreibung**

Die Erfindung bezieht sich auf ein Verfahren zur Messung kleiner Ströme sowie auf eine Schaltung zur Durchführung dieses Verfahrens.

In vielen Meßgeräten, z. B. in Massenspektrometern, Vakuummeßgeräten usw., erfolgt die Meßwertbildung aufgrund von Strömen, die von positiv oder negativ geladenen, auf eine Elektrode auftreffende Teilchen erzeugt werden. Der dynamische Bereich der auftretenden und zu messenden Ionen- oder Elektronenstromstärken ist sehr groß. Er reicht häufig von einigen hundert atto-Ampere bis zu einigen mikro-Ampere und überstreicht damit mehr als neun Dekaden.

Der vorliegenden Erfindung liegt die Aufgabe zugrunde, ein Verfahren zur Messung von Strömen dieser Größenordnung sowie eine zur Durchführung dieses Meßverfahrens geeignete Schaltung vorzuschlagen, mit deren Hilfe die Meßwertbildung schnell, genau und störungsfrei möglich ist.

Das erfindungsgemäße Meßverfahren ist durch die Merkmale der Patentansprüche 1 bis 5, die erfindungsgemäße Schaltung durch die Merkmale der Patentansprüche 6 bis 14 gekennzeichnet.

Der besondere Vorteil des erfindungsgemäßen Meßverfahrens liegt darin, daß alle Strombereichsausgänge parallel einschwingen, so daß die Meßsignale unabhängig von der Größe des Eingangsstromes durch den nachgeschalteten Multiplexer ausgewählt und gelesen werden können. Dadurch wird beispielsweise eine softwaremäßige Logarithmierung ermöglicht. Die Meßwertbildung erfolgt sehr schnell, zusätzlich unterstützt durch den Vorteil, daß die Schaltung sehr schnell (mit kurzen Zeitkonstanten) ausgeführt werden kann. Wegen der kleinen Zeitkonstanten kann die Mittelungszeit per Software in einem weiten Bereich gewählt werden, indem aus vielen Einzelmessungen gemittelt wird. Eine Offsetberücksichtigung ist in einfacher Weise möglich, indem zu einem Zeitpunkt, zu dem kein Eingangsstrom fließt, alle Strombereichsausgänge gemessen und dieser Wert während der normalen Messung als Offsetwert subtrahiert wird.

Der Aufwand und der Platzbedarf für die erfindungsgemäße Schaltung sind gering. Die Schaltung benötigt keine Relais' und ist dadurch störunempfindlich.

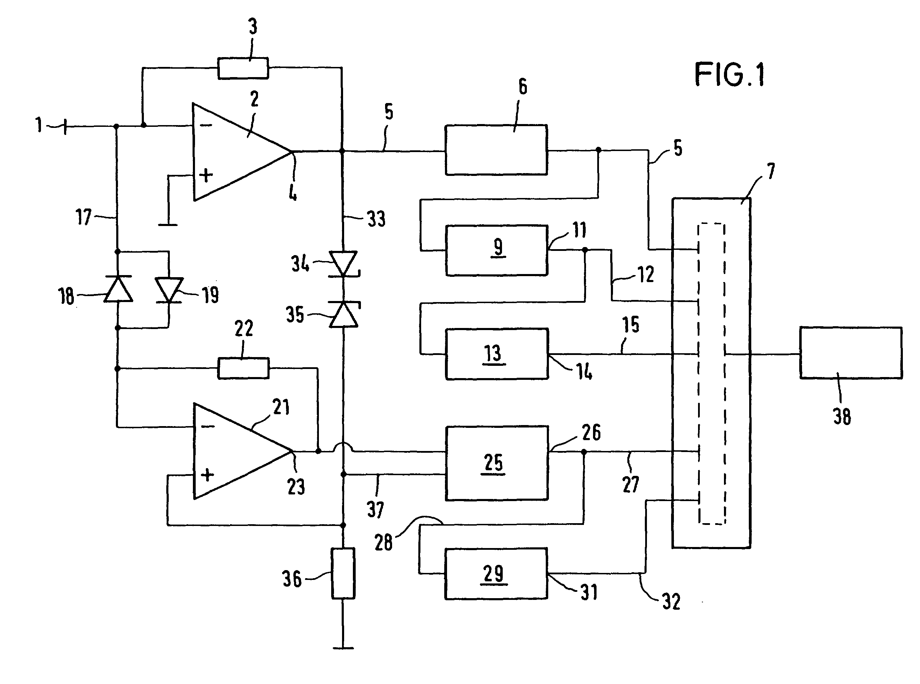

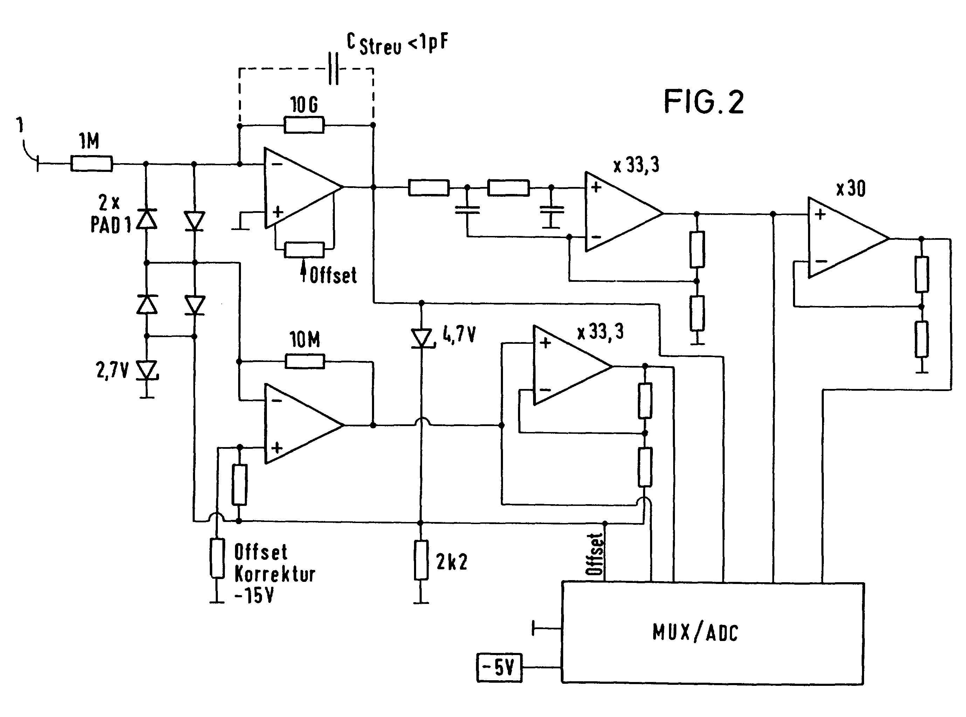

Weitere Vorteile und Einzelheiten der Erfindung sollen anhand von in den Figuren 1 und 2 dargestellten Schaltskizzen erläutert werden.

Beim Prinzip-Schaltbild nach Figur 1 ist der Eingang der Schaltung mit 1 bezeichnet. An den Eingang 1 schließt sich ein Operationsverstärker 2 mit seinem Rückkoppelwiderstand 3 an. Der Ausgang 4 des Operationsverstärkers 2 ist über die Leitung 5, in der sich ein Tiefpaß 6 befindet, mit dem Multiplexer 7 verbunden. Der Ausgang des Tiefpasses 6 ist außerdem noch an den Eingang eines Verstärkers 9 angeschlossen, dessen Ausgang 11 über die Leitung 12 mit dem Multiplexer 7 verbunden ist. Zusätzlich ist der Ausgang 11 des Verstärkers 9 an den Eingang des Verstärkers 13 angeschlossen, dessen Ausgang 14 über die Leitung 15 mit dem Multiplexer 7 verbunden ist.

An den Signaleingang 1 schließt sich weiterhin eine Leitung 17 mit zwei anti parallel geschalteten Dioden 18, 19 an. Diese Leitung 17 führt zum Eingang eines zweiten Operationsverstärkers 21 mit seinem Rückkoppelwiderstand 22. Der Ausgang 23 dieses Operationsverstärkers ist zu einem der beiden Eingänge eines Differenzverstärkers 25 geführt. Der Ausgang 26 des Differenzverstärkers ist über die Leitung 27 mit dem Multiplexer 7 und zusätzlich noch über die Leitung 28 mit dem Eingang eines weiteren Verstärkers 29 verbunden, dessen Ausgang 31 über die Leitung 32 mit dem Multiplexer verbunden ist.

Schließlich ist noch die Leitung 33 mit den beiden in Reihe geschalteten Dioden 34 und 35 sowie mit dem geerdeten Widerstand 36 vorgesehen. Zwischen den Dioden 34, 35 und dem Widerstand 36 ist eine Leitung 37 angeschlossen, die mit dem zweiten Eingang des Differenzverstärkers 25 verbunden ist. Außerdem steht dieser Leitungsabschnitt mit dem nicht invertierenden Eingang des Operationsverstärkers 21 in Verbindung.

An den Multiplexer 7 schließt sich noch der Analog-Digital-Wandler 38 an.

Die dargestellte Schaltung ist in der Lage, Eingangsströme mit einem großen dynamischen Bereich zu messen. Wenn der Eingangsstrom klein ist, d.h. wenn er im unteren Strommeßbereich liegt, fällt am Widerstand 3 eine relativ kleine Spannung ab, d.h., die Dioden 34, 35 werden nicht leitend. In der Leitung 33 fließt deshalb kein Strom, so daß auch am Widerstand 36 keine Spannung abfällt. Der zweite Operationsverstärker 21 regelt damit seinen Minuseingang auf 0 V, so daß auch keine Spannung an den Dioden 18, 19 liegt. Dadurch sind diese Dioden gesperrt. Der (kleine) Eingangsstrom fließt deshalb nur in den Widerstand 3 hinein, so daß am Ausgang 4 des Operationsverstärkers 2 Spannungen gemessen werden können, die proportional zum Eingangsstrom sind. Der Ausgang 4 des Operationsverstärkers 2 bildet damit einen der Strombereichsausgänge, die mit dem Multiplexer 7 verbunden sind.

Die von sehr kleinen Eingangsströmen herrührenden Spannungssignale können außerdem noch mit Hilfe der Verstärker 9 und 13 verstärkt werden. Die Ausgänge 11 und 14 dieser Verstärker sind ebenfalls mit dem Multiplexer 7 verbunden und bilden damit weitere Strombereichsausgänge. Bei kleinsten Eingangsströmen, d.h. wenn der Ausgang 14 noch nicht übersteuert ist, wird an diesem Ausgang gemessen. Bei Eingangsströmen zunehmender Größe liefert der Verstärker 13 übersteuerte Signale, so daß auf den Ausgang 11 des Verstärkers 9 übergegangen werden muß. Solange dieser Verstärker 9 keine übersteuerten Signale liefert, wird das vom Ausgang 11 gelieferte Signal als Meßsignal herangezogen. Bei weiterer Erhöhung des Eingangs stromes muß in gleicher Weise auf den Ausgang 4 des Operationsverstärkers 2 übergegangen werden.

Die Dioden 34 und 35 sind derart dimensioniert, daß sie etwa dann leitend werden, wenn der Meßbereich, in dem der Signalbereichsausgang 4 des Operationsverstärkers 2 ordentliche Meßwerte liefert, ausgeschöpft ist. Am Widerstand 36 fällt dann eine Spannung ab, die sich infolge der Regeleigenschaft des Operationsverstärkers 21 auch an seinem Negativ-Eingang ausbildet. Der in den Eingang 1 einfließende Eingangsstrom kann sich deshalb aufteilen und wird von beiden Operationsverstärkern 2 und 21 registriert. Die Aufteilung erfolgt in der Weise, daß ein konstant bleibender Anteil in den Widerstand 3 einfließt, während der jeweilige Überschuß-Anteil in den Widerstand 22 des Operationsverstärkers 21 einfließt. Der Strombereichsausgang 4 des Operationsverstärkers 2 liefert damit an den Multiplexer 7 ein konstantes Spannungssignal, das im linearen Bereich liegt. Desgleichen liefert der Ausgang 23 des Operationsverstärkers 21 ein Signal, das dem Überschußanteil entspricht, wobei dieses Signal mit der Flußspannung der Dioden 18 und 19 fehlerbehaftet ist. Da diese Spannung auch am Eingang des Differenzverstärkers 25 (Leitung 37) liegt, steht am Ausgang des Differenzverstärkers 25 die korrigierte Spannung an und wird unmittelbar über Leitung 26 oder einmals verstärkt (Verstärker 29) dem Multiplexer 7 zugeführt.

An dieser Stelle ist eine Vereinfachung der Schaltung möglich, wobei der Ausgang des Verstärkers 21 direkt mit dem Multiplexer 7 verbunden ist. Die Korrektur, die beim dargestellten Ausführungsbeispiel der Differenzverstärker 25 übernimmt, muß dann durch die Verbindung der Leitung 37 zum Multiplexer 7 der Software zugänglich gemacht werden, die dann die Differenz bildet. Der Strompfad für kleine Ströme kann auch zwei Ausgänge aufweisen und/oder über einen Feldeffekt-Transistor geführt sein. Ist ein dritter Strompfad vorhanden, so kann dieser am zweiten aufgehängt sein. Die Leitfähigkeit zusätzlicher, zu den Bauteilen 18, 19 korrespondierender Bauteile wird zweckmäßiger vom Verstärkerausgangssignal 23 abgeleitet. Es besteht aber auch die Möglichkeit, den dritten Strompfad direkt an den Eingang 1 anzuschließen und die Leitfähigkeit der Bauteile vom Verstärkerausgang 4 abzuleiten.

Die Software, die den Multiplexer 7 steuert, hat zum einen die Aufgabe, jeweils festzustellen, welcher der Signalbereichsausgänge 4, 11, 14, 26, 31 einen gültigen Signalwert liefert, der zur Meßwertbildung herangezogen wird. Geht man vom empfindlichsten Signalbereichsausgang 14 aus, dann kann beispielsweise anhand einer Bereichsüberschreitung der richtige Wert gefunden werden. Lediglich beim Übergang vom unempfindlichsten Strombereichsausgang 4 der ersten Verstärkergruppe (2, 9, 13) zum empfindlichsten Ausgang 31 der zweiten Verstärkergruppe (25, 29) muß bereits innerhalb des Bereichs, der dem Ausgang 31 zugeordnet ist, gemessen werden, da der Strombereichsausgang 4 nach dem Übergang auf einer Spannung gehalten wird, die im linearen Bereich liegt. Zu den gemessenen Signalen an den Ausgängen 26 und 31 muß das gemessene Signal am Ausgang 4 addiert werden, um ein dem Eingangsstrom proportionales Ausgangssignal zu erhalten. Auch diese Funktion nimmt die den Multiplexer 7 steuernde Software wahr. Mit Hilfe des Analog-Digital-Wandlers 38 erfolgt die Aufbereitung der Signale für den sich anschließenden Prozessor.

In Fällen, in denen der Eingangsstrom sich derart rasch über viele Dekaden ändert, daß die Speicherzeiten der Dioden 18 und 19 sich störend bemerkbar machen, kann durch Einfügen eines Schalters (z.B. Feldeffekt-Transistor) in die Leitung 17, der bei Strömen abschaltet, bei denen die Dioden 18 und 19 nicht leitend sein sollten, der Einfluß weitgehend vermieden werden.

Als Rückkoppelbauteile 3 und 22 der Operationsverstärker 2 und 21 sind Widerstände dargestellt. Es können auch - vorzugsweise - Kondensatoren oder nichtlineare Bauteile eingesetzt werden. Wesentlich ist, daß sich durch die Wahl der Rückkoppelbauteile eine gleichstufige Bereichserweiterung ergibt, d.h., daß die Stufe eines höheren Strombereichs um den Faktor V über der letzten Stufe des niedrigeren Bereichs liegt. Der Verstärkungsfaktor V hängt von der gewünschten Auflösung im Übergangsbereich ab. Je kleiner dieser gewählt wird, um so kleiner wird auch die Auflösung jeweils zu Anfang eines jeden Bereichs. Sind beispielsweise fünf Ausgänge vorhanden, dann ergibt sich:

$$\frac{\text{maximaler Strom}}{\text{Strom-Auflösung}} = V * V * V * V * \frac{\text{maximaler Wert ADC}}{\text{Auflösung ADC}}$$

Wenn für V = 31.6 gewählt wird ergibt sich bei einem 12 Bit ADC und bipolarer Strommessung als Verhältnis:

$$\frac{\text{maximaler Strom}}{\text{Strom-Auflösung}} = 31.6 * 31.6 * 31.6 * 31.6 * (+\text{-}2048)$$

$$= +\text{- } 2,048 \, E \, 9$$

Figur 2 zeigt ein Dimensionierungsbeispiel für eine Schaltung nach Figur 1 für die Messung von Strömen, die von positiv geladenen Teilchen erzeugt werden. Bezüglich der Dioden 34, 35, welche den Übergang von der Meßwertbildung mit Hilfe eines einzigen Signals auf die Meßwertbildung durch ein Summensignal bestimmen, gilt folgendes: Wenn der AD-Wandler 38 für eine maximale Spannung von 5 V ausgelegt ist, sollte die Arbeitsspannung der Dioden 34 und 35 etwas geringer sein als z.B. 4,7 V, d.h., der Eingangsstrom wäre im Übergangsbereich

$$I = \frac{4,7\ V + \text{Diodenflußspannung (D 34, 35)}}{\text{Widerstand 3}}$$

Beim Überschreiten bestimmter Spannungswerte geht der Multiplexer über zum nächsten Eingang. Die Vorgehensweise ist die folgende: Die Software liest den empfindlichsten Eingang ein. Wenn der eingelesene Wert dem Endwert des AD-Wandlers entspricht, muß der Multiplexer auf den nächstunempfindlicheren Kanal geschaltet und nochmals ein Wert eingelesen werden. Dies wird solange fortgesetzt, bis der AD-Wandler nicht mehr auf seinem Endwert steht.

**Patentansprüche**

1.  Verfahren zur Messung von Strömen mit Hilfe einer elektronischen Schaltung, <u>dadurch gekennzeichnet,</u>

    -   dass sich an den Eingang (1) der Schaltung zwei Strompfade anschließen,

    -   dass die Messung von Strömen mit sehr kleinen Stromstärken dadurch erfolgt, dass die Stromsignale bei gesperrtem zweiten Strompfad mittels im ersten Strompfad befindlicher, hintereinander angeordneter Verstärker (2, 9, 13) verstärkt werden und dass von den an den Ausgängen dieser Verstärker anliegenden Signalen das jeweils zutreffende Signal ausgewählt und als Messsignal weitergeleitet wird,

    -   dass die Sperrung des zweiten Strompfades während der Messung von Strömen mit sehr kleinen Stromstärken dadurch erfolgt, dass sich im zweiten Strompfad eine Diode oder mehrere Dioden (18, 19) befindet (befinden), deren Leitfähigkeit sich in Abhängigkeit vom Ausgangssignal des Verstärkers (2) im ersten Strompfad derart ändert, dass sie bei Strömen mit kleinen Stromstärken gesperrt und bei Strömen mit größeren Stromstärken leitend ist (sind) und

    -   dass die Messung von Strömen mit größeren Stromstärken dadurch erfolgt, dass die Stromsignale auf den ersten und den zweiten Strompfad derart aufgeteilt werden, dass ein konstant bleibender Anteil in den ersten Strompfad und der Überschussanteil in den zweiten Strompfad einfließt, dass die in den zweiten Strompfad einfließenden Stromsignale mittels hintereinander angeordneter Verstärker (21, 25, 29) verstärkt werden, dass von den an den Ausgängen dieser Verstärker anliegenden Signalen das jeweils zutreffende Signal ausgewählt wird und dass dieses Signal mit dem konstanten Signal des ersten Strompfades addiert und das Summensignal als Messsignal weitergeleitet wird.

2.  Verfahren nach Anspruch 1, <u>dadurch gekennzeichnet,</u> dass die von den Strombereichsausgängen der Verstärker (2, 9, 13, bzw. 21, 25, 29) gelieferten Signale einem Multiplexer (7) zugeführt werden und dass ein Analog-Digital-Wandler (38) die Ströme umwandelt, die in einer Softwareroutine zur weiteren Bearbeitung und Steuerung des Multiplexers benutzt werden.

3.  Verfahren nach Anspruch 2, <u>dadurch gekennzeichnet,</u> dass Ströme mit kleinen Stromstärken dem Eingang eines ersten Operationsverstärkers (2) zugeführt werden, dass die Spannungsausgangssignale des Operationsverstärkers sowohl dem Multiplexer (7) direkt als auch einem Verstärker (9) zugeführt werden, dass Ströme mit größeren Stromstärken durch Erniedrigung der Leitfähigkeit der Dioden (18, 19) in einen dem ersten Operationsverstärker (2) zugeführten Konstantanteil und einen in einem weiteren Strompfad geführten Überschussanteil aufgeteilt werden und dass die von den Signalbereichsausgängen (4, 11, 14 und 26, 31 bzw. 23, 37) der Verstärker (2, 9, 13 und 25, 29 bzw. 21) gelieferten Signale dem Multiplexer (7) zugeführt werden.

4.  Verfahren nach einem der vorhergehenden Ansprüche, <u>dadurch gekennzeichnet,</u> dass bei fehlendem Eingangsstrom alle von den Bereichsausgängen gelieferten Werte gemessen und registriert werden und dass beim nachfolgenden Messen von Eingangsströmen diese Werte als Offsetwerte subtrahiert werden.

5.  Verfahren nach einem der vorhergehenden Ansprüche <u>dadurch gekennzeichnet,</u> dass die Fehlerspannung am Ausgang (23) des Operationsverstärkers (21) dem Multiplexer (7) zugeführt wird und dass der Fehler in der Software korrigiert wird.

6.  Schaltung zur Durchführung eines Verfahrens zur Messung von Strömen

    -   bei dem der Durchführung der Messung der Ströme zwei Strompfade dienen,

    -   bei dem die Messung von Strömen mit sehr kleinen Stromstärken dadurch erfolgt, dass die Stromsignale bei gesperrtem zweiten Strompfad mittels im ersten Strompfad befindlicher, hintereinander angeordneter Verstärker (2, 9, 13) verstärkt werden und dass von den an den Ausgängen dieser Verstärker anliegenden Signalen das jeweils zutreffende Signal ausgewählt und als Messsignal weitergeleitet wird,

    -   bei dem die Sperrung des zweiten Strompfades während der Messung von Strömen mit sehr kleinen Stromstärken dadurch erfolgt, dass sich im zweiten Strompfad eine Diode oder mehrere Dioden (18, 19) befindet (befinden), deren Leitfähigkeit sich in Abhängigkeit vom Ausgangssignal eines der Verstärker (2) im ersten Strompfad derart ändert, dass sie bei Strömen mit kleinen Stromstärken gesperrt und bei Strömen mit größeren Stromstärken leitend ist (sind), und

    -   bei dem die Messung von Strömen mit größeren Stromstärken dadurch erfolgt, dass die Stromsignale auf den ersten und den zweiten Strompfad derart aufgeteilt werden, dass ein konstant bleibender Anteil in den ersten Strompfad und der Überschussanteil in den zweiten Strompfad einfließt, dass die in den zweiten Strompfad einfließenden Stromsignale mittels hintereinander angeordneter Verstärker (21, 25, 29) verstärkt werden, dass von den an den Ausgängen dieser Verstärker anliegenden Signalen das jeweils zutreffende Signal ausgewählt wird und dass dieses Signal mit dem konstanten Signal des ersten Strompfades addiert und das Summensignal als Messsignal weitergeleitet wird, <u>dadurch gekennzeichnet,</u>

    -   dass der erste Verstärker (2) ein Operationsverstärker ist und dass der Eingang dieses Verstärkers (2) den Signaleingang (1) bildet,

    -   dass sich an den Ausgang (4) des Operationsverstärkers (2) die den ersten Strompfad bildenden, in Reihe geschalteten Verstärker (9, 13) anschließen, und

    -   dass die den zweiten Strompfad sperrende(n) oder öffnende(n) Diode(n) (18, 19) mit änderbarer Leitfähigkeit an den Signaleingang (1) angeschlossen ist (sind), deren weiterer Anschluss mit dem Eingang des Verstärkers (21) verbunden ist, der ein Operationsverstärker ist und an dessen Ausgang sich die den zweiten Strompfad bildenden, in Reihe geschalteten Verstärker (25, 29) anschließen, wobei sich die Leitfähigkeit der Diode(n) (18, 19) in Abhängigkeit vom Ausgangssignal des Verstärkers (2) im ersten Strompfad derart ändert, dass der Signaleingang (1) bei Strömen mit größeren Stromstärken über die Diode(n) (18, 19) mit dem Eingang des weiteren Operationsverstärkers (21) verbunden ist.

7.  Schaltung nach Anspruch 6, <u>dadurch gekennzeichnet,</u> dass die Signalausgänge der Verstärker (2, 6, 9 bzw. 21, 25, 29) mit einem Multiplexer (7) verbunden sind und dass ein Analog-Digital-Wandler (38) daran angeschlossen ist.

8.  Schaltung nach Anspruch 6 oder 7, <u>dadurch gekennzeichnet,</u> dass Dioden (18, 19) benutzt werden, die durch Spannungsänderung am nichtinvertierenden Eingang des weiteren vom Operationsverstärker (21) gebildeten Strompfades ihre Leitfähigkeit ändern, und dass ein Differenzverstärker vorgesehen ist, mit dem die der Flussspannung der Dioden entsprechende Fehlerspannung an dem Ausgang (23) des Operationsverstärkers (21) korrigiert wird.

9.  Schaltung nach Anspruch 6, 7, oder 8, <u>dadurch gekennzeichnet,</u> dass an den Ausgang (4) des Operationsverstärkers (2) eine Leitung (33) mit weiteren nichtlinearen Bauteilen, z.B. Zener-Dioden, und einem geerdeten Widerstand (36) angeschlossen ist, die die Spannungsänderung am nichtinvertierenden Eingang des Operationsverstärkers (21) verursachen.

10. Schaltung nach einem der Ansprüche 6 bis 9, <u>dadurch gekennzeichnet,</u> dass in mindestens einem Verstärkerzweig, z.B. zwischen dem Ausgang (4) des ersten Operationsverstärkers (2) und dem eingang des Multiplexers (7) bzw. dem Eingang des sich anschließenden Verstärkers (9), ein Tiefpass (6) angeordnet ist.

11. Schaltung nach einem der Ansprüche 6 bis 10, <u>dadurch gekennzeichnet,</u> dass sich im zweiten Strompfad mindestens ein Feldeffekt-Transistor und/oder Dioden befinden und dass die Feldeffekt-Transistoren durch den Ausgang (4) des Operationsverstärkers (2) bzw. einer der vorherigen Stufen ihre Leitfähigkeit ändern.

12. Schaltung nach einem der Ansprüche 6 bis 11, <u>dadurch gekennzeichnet,</u> dass mindestens eines der Rückkoppelbauteile (3, 22) für die Operationsverstärker (2, 21) über einen Spannungteiler am Operationsverstärkerausgang angeschlossen ist.

13. Schaltung nach einem der Ansprüche 6 bis 12, <u>dadurch gekennzeichnet,</u> dass für mindestens eines der Rückkoppelbauteile (3, 22) für die Operationsverstärker (2, 21) ein Kondensator eingesetzt wird.

14. Schaltung nach einem der Ansprüche 6 bis 12, <u>dadurch gekennzeichnet,</u> dass für mindestens eines der Rückkoppelbauteile (3, 22) für die Operationsverstärker (2, 21) ein Kennlinienbauteil, z.B. eine Diode, eingesetzt wird, um eine logarithmische Kennlinie zu erhalten.

## Claims

1. Method for measuring currents by means of an electronic circuit, characterised in

   - that two current paths adjoin the input (1) of the circuit,

   - that currents of very low current strengths are measured by amplifying the current signals by means of series-connected amplifiers (2, 9, 13) located in the first current path, with the second current path blocked, and by selecting the signal appropriate in each case from the signals present at the outputs of these amplifiers and transmitting this signal as measurement signal,

   - that the second current path is blocked while measuring currents of very low current strengths by locating a diode or a plurality of diodes (18, 19) in the second current path whose conductivity varies in accordance with the output signal of the amplifier (2) in the first current path such that it (they) is (are) blocked in the case of currents of low current strengths and conductive in the case of currents of higher current strengths, and

   - that currents of higher current strengths are measured by dividing the current signals between the first and the second current path such that a component which remains constant flows into the first current path and the excess component flows into the second current path, by amplifying the current signals flowing into the second current path by means of series-connected amplifiers (21, 25, 29), by selecting the signal appropriate in each case from the signals present at the outputs of these amplifiers, and by adding this signal to the constant signal of the first current path and transmitting the composite signal as measurement signal.

2. Method according to claim 1, characterised in that the signals delivered by the current range outputs of the amplifiers (2, 9, 13 or 21, 25, 29) are fed to a multiplexer (7), and that an analogue-digital converter (38) converts the currents, which are used in a software routine for further processing and controlling the multiplexer.

3. Method according to claim 2, characterised in that currents of low current strengths are fed to the input of a first operational amplifier (2), that the voltage output signals of the operational amplifier are fed both to the multiplexer (7) directly and to an amplifier (9), that, by lowering the conductivity of the diodes (18, 19), currents of higher current strengths are divided into a constant component, which is fed to the first operational amplifier (2), and an excess component, which is conducted in a further current path, and that the signals delivered by the signal range outputs (4, 11, 14 and 26, 31 or 23, 37) of the amplifiers (2, 9, 13 and 25, 29 or 21) are fed to the multiplexer (7).

4. Method according to one of the preceding claims, characterised in that all the values delivered by the range outputs are measured and recorded in the absence of an input current, and that these values are subtracted as offset values when subsequently measuring input currents.

5. Method according to one of the preceding claims, characterised in that the error voltage at the output (23) of the operational amplifier (21) is fed to the multiplexer (7), and that the error is corrected in the software.

6. Circuit for carrying out a method for measuring currents

   - in which two current paths are used to measure the currents,

- in which currents of very low current strengths are measured by amplifying the current signals by means of series-connected amplifiers (2, 9, 13) located in the first current path, with the second current path blocked, and by selecting the signal appropriate in each case from the signals present at the outputs of these amplifiers and transmitting this signal as measurement signal,

- in which the second current path is blocked while measuring currents of very low current strengths by locating a diode or a plurality of diodes (18, 19) in the second current path whose conductivity varies in accordance with the output signal of one of the amplifiers (2) in the first current path such that it (they) is (are) blocked in the case of currents of low current strengths and conductive in the case of currents of higher current strengths, and

- in which currents of higher current strengths are measured by dividing the current signals between the first and the second current path such that a component which remains constant flows into the first current path and the excess component flows into the second current path, by amplifying the current signals flowing into the second current path by means of series-connected amplifiers (21, 25, 29), by selecting the signal appropriate in each case from the signals present at the outputs of these amplifiers, and by adding this signal to the constant signal of the first current path and transmitting the composite signal as measurement signal, characterised in

- that the first amplifier (2) is an operational amplifier, and that the input of this amplifier (2) forms the signal input (1),

- that the series-connected amplifiers (9, 13) which form the first current path adjoin the output (4) of the operational amplifier (2), and

- that the diode(s) (18, 19) of variable conductivity which block(s) or open(s) the second current path is (are) connected to the signal input (1), the other terminal of which is connected to the input of the amplifier (21), which is an operational amplifier and the output of which is adjoined by the series-connected amplifiers (25, 29), which form the second current path, wherein the conductivity of the diode(s) (18, 19) varies in accordance with the output signal of the amplifier (2) in the first current path such that the signal input (1) is connected to the input of the other operational amplifier (21) via the diode(s) (18, 19) in the case of currents of higher current strengths.

7. Circuit according to claim 6, characterised in that the signal outputs of the amplifiers (2, 6, 9 or 21, 25, 29) are connected to a multiplexer (7), and that an analogue-digital converter (38) is connected to the latter.

8. Circuit according to claim 6 or 7, characterised in that diodes (18, 19) are used which vary their conductivity through a voltage variation at the non-inverting input of the further current path formed by the operational amplifier (21), and that a differential amplifier is provided for correcting the error voltage at the output (23) of the operational amplifier (21), which corresponds to the forward voltage of the diodes.

9. Circuit according to claim 6, 7 or 8, characterised in that a line (33) with further non-linear component parts, e.g. Zener diodes, and an earthed resistor (36) is connected to the output (4) of the operational amplifier (2), these causing the voltage variation at the non-inverting input of the operational amplifier (21).

10. Circuit according to one of claims 6 to 9, characterised in that a low-pass filter (6) is disposed in at least one amplifier branch, e.g. between the output (4) of the first operational amplifier (2) and the input of the multiplexer (7) or the input of the adjoining amplifier (9).

11. Circuit according to one of claims 6 to 10, characterised in that at least one field-effect transistor and/or diodes is/are located in the second current path, and that the field-effect transistors vary their conductivity through the output (4) of the operational amplifier (2) or one of the preceding stages.

12. Circuit according to one of claims 6 to 11, characterised in that at least one of the feedback component parts (3, 22) for the operational amplifiers (2, 21) is connected to the operational amplifier output via a voltage divider.

13. Circuit according to one of claims 6 to 12,
characterised in that a capacitor is used for at least one of the feedback component parts (3, 22) for the operational amplifiers (2, 21).

14. Circuit according to one of claims 6 to 12,
characterised in that a characteristic component part, e.g. a diode, is used for at least one of the feedback component parts (3, 22) for the operational amplifiers (2, 21) in order to obtain a logarithmic characteristic.

**Revendications**

1. Procédé de mesure de courants à l'aide d'un circuit électronique, caractérisé en ce que

   - deux trajets de courant se raccordent à l'entrée (1) du circuit,
   - en ce que la mesure de courants s'effectue à l'aide de très faibles intensités de courant, en ce que les signaux de courant dans le cas d'un blocage du second trajet de courant sont amplifiés à l'aide d'amplificateurs (2, 9, 13) disposés en succession, se trouvant dans le premier trajet de courant et en ce que, parmi les signaux apparaissant aux sorties de ces amplificateurs, le signal concerné respectif est sélectionné et transmis en tant que signal de mesure,
   - en ce que le blocage du second trajet de courant durant la mesure de courants s'effectue à l'aide de très faibles intensités de courant, en ce que, dans le second trajet de courant, se trouve(nt) une ou plusieurs diode (s) (18, 19), dont la conductibilité varie en fonction du signal de sortie de l'amplificateur (2) dans le premier trajet de courant, de telle sorte qu'elle(s) est (sont) bloquée(s) pour des courants de faibles intensités et est (sont) conductrice(s) pour des courants de plus fortes intensités, et
   - en ce que la mesure de courants s'effectue à l'aide de fortes intensités de courant de telle sorte que les signaux de courant sont répartis sur le premier et sur le second trajet de courant, de telle sorte qu'une composante constante circule dans le premier trajet de courant et la composante excédentaire dans le second trajet de courant, en ce que les signaux de courant circulant dans le second trajet de courant sont amplifiés au moyen d'amplificateurs (21, 25, 29) disposés en succession, en ce que, parmi les signaux apparaissant aux sorties de ces amplificateurs, le signal concerné respectif est sélectionné, et en ce que ce signal est additionné au signal constant du premier trajet de courant et le signal somme est transmis en tant que signal de mesure.

2. Procédé selon la revendication 1, caractérisé en ce que les signaux délivrés par les sorties de plage de courant des amplificateurs (2, 9, 13, respectivement, 21, 25, 29) sont appliqués à un multiplexeur (7) et en ce qu'un convertisseur analogique-numérique (38) convertit les courants, qui sont utilisés dans un programme de logiciel en vue d'un autre traitement et de la commande du multiplexeur.

3. Procédé selon la revendication 2, caractérisé en ce que des courants de faible intensité sont appliqués à l'entrée d'un premier amplificateur opérationnel (2), en ce que les signaux de sortie de tension de l'amplificateur opérationnel sont appliqués non seulement directement au multiplexeur (7), mais également à un amplificateur (9), en ce que des courants de forte intensité sont partagés par abaissement de la conduction des diodes (18, 19) en une composante constante appliquée au premier amplificateur opérationnel (2) et en une composante excédentaire appliquée à un second trajet de courant et en ce que les signaux délivrés par les sorties de plage de signal (4, 11, 14 et 26, 31, respectivement 23, 37) des amplificateurs (2, 9, 13 et 25, 29, respectivement 21) sont appliqués au multiplexeur (7).

4. Procédé selon l'une quelconque des revendications précédentes, caractérisé en ce que, dans le cas d'un courant d'entrée manquant, toutes les valeurs délivrées par les sorties de plage sont mesurées et enregistrées et en ce qu'après mesure des courants d'entrée, ces valeurs sont retranchées en tant que valeurs de décalage.

5. Procédé selon l'une des revendications précédentes, caractérisé en ce que la tension d'erreur à la sortie (23) de l'amplificateur opérationnel (21) est appliquée au multiplexeur (7) et en ce que l'erreur est corrigée dans le logiciel.

6. Circuit de mise en oeuvre d'un procédé de mesure de courants

   - dans lequel, en vue de la mise en oeuvre de la mesure des courants sont utilisés deux trajets de courant,
   - dans lequel la mesure de courants s'effectue à de très faibles intensités de courant, en ce que les signaux de courant dans le cas du second trajet de courant bloqué sont amplifiés au moyen d'amplificateurs (2, 9, 13) disposés en succession, se trouvant dans le premier trajet de courant et en ce que, parmi les signaux apparaissant aux sorties de ces amplificateurs, le signal concerné respectif est sélectionné et transmis en tant que signal de mesure,

- dans lequel le blocage du second trajet de courant durant la mesure de courants s'effectue à de très faibles intensités de courant, en ce que, dans le second trajet de courant se trouve(nt) une ou plusieurs diode(s) (18, 19), dont la conductibilité varie en fonction du signal de sortie d'un des amplificateurs (2) dans le premier trajet de courant, de sorte qu'elle(s) est (sont) bloquée(s) pour des courants de faible intensité et est(sont) conductrice(s) pour des courants de forte intensité, et

- dans lequel la mesure de courants s'effectue à des intensités de courant importantes, en ce que les signaux de courant sont répartis sur le premier et le second trajet de courant de telle sorte qu'une composante constante circule dans le premier trajet de courant et la composante excédentaire dans le second trajet de courant, en ce que les signaux de courant circulant dans le second trajet de courant sont amplifiés à l'aide d'amplificateurs disposés en succession (21, 25, 29), en ce que parmi les signaux apparaissant aux sorties de ces amplificateurs, le signal concerné respectif est sélectionné et en ce que ce signal est ajouté au signal constant du premier trajet de courant et le signal somme est transmis en tant que signal de mesure, caractérisé

- en ce que le premier amplificateur (2) est un amplificateur opérationnel et en ce que l'entrée de cet amplificateur (2) forme l'entrée de signal (1),

- en ce qu'à la sortie (4) de l'amplificateur opérationnel (2) sont raccordés les amplificateurs (9, 13) montés en série, formant le premier trajet de courant, et

- en ce que la(les) diode(s) (18, 19) bloquant ou ouvrant le second trajet de courant est(sont) reliée(s) à conductibilité variable à l'entrée de signal (1), dont l'autre borne est reliée à l'entrée de l'amplificateur (21), qui est un amplificateur opérationnel et à la sortie duquel sont reliés les amplificateurs (25, 29) montés en série formant le second trajet de courant, la conductibilité de la(des) diode(s) (18, 19) varie en fonction du signal de sortie de l'amplificateur (2) dans le premier trajet de courant, en ce que l'entrée de signal (1) est reliée pour des courants de forte intensité par l'intermédiaire de la(des) diode(s) (18, 19) à l'entrée de l'autre amplificateur opérationnel (21).

7. Circuit selon la revendication 6, caractérisé en ce que les sorties de signal des amplificateurs (2, 6, 9 respectivement 21, 25, 29) sont reliées à un multiplexeur (7) et en ce qu'un convertisseur analogique-numérique (38) est relié à celui-ci.

8. Circuit selon la revendication 6 ou 7, caractérisé en ce que des diodes (18, 19) sont utilisées, qui modifient leur conductibilité par variation de tension à l'entrée sans inversion de l'autre trajet de courant formé par l'amplificateur opérationnel (21), et en ce qu'un amplificateur différentiel est prévu, à l'aide duquel est corrigée la tension d'erreur correspondant à la tension directe des diodes à la sortie (23) de l'amplificateur opérationnel (21).

9. Circuit selon la revendication 6, 7 ou 8, caractérisé en ce qu'à la sortie (4) de l'amplificateur opérationnel (2) est reliée une ligne (33) avec d'autres composants non linéaires, par exemple des diodes Zener, et une résistance (36) reliée à la terre, qui provoquent la variation de tension à l'entrée sans inversion de l'amplificateur opérationnel (21).

10. Circuit selon l'une des revendications 6 à 9, caractérisé en ce que, dans au moins une branche d'amplificateur, par exemple entre la sortie (4) du premier amplificateur opérationnel (2) et l'entrée du multiplexeur (7) ou l'entrée de l'amplificateur (9) s'y raccordant, est disposé un filtre passe-bas (6).

11. circuit selon l'une des revendications 6 à 10, caractérisé en ce que dans le second trajet de courant se trouvent au moins un transistor à effet de champ et/ou des diodes et en ce que les transistors à effet de champ modifient leur conductibilité par la sortie (4) de l'amplificateur opérationnel (2) ou l'un des étages antérieurs.

12. Circuit selon l'une des revendications 6 à 11, caractérisé en ce qu'au moins un des composants de réaction (3, 22) pour les amplificateurs opérationnels (2, 21) est relié par l'intermédiaire d'un diviseur de tension à la sortie de l'amplificateur opérationnel.

13. Circuit selon l'une des revendications 6 à 12, caractérisé en ce que, pour au moins un des composants de réaction (3, 22) pour les amplificateurs opérationnels (2, 21) est utilisé un condensateur.

14. Circuit selon l'une des revendications 6 à 12, caractérisé en ce que, pour au moins un des composants de réaction (3, 22) pour les amplificateurs opérationnels (2, 21) est utilisé un composant à courbe caractéristique, par exemple une diode, afin d'obtenir une caractéristique logarithmique.

FIG.1

FIG.2

$C_{Streu} < 1pF$

10 G

1M

1

2 x
PAD 1

2,7V

10 M

x 33,3

x 30

Offset

4,7V

x 33,3

Offset
Korrektur
-15V

2k2

Offset

MUX/ADC

-5V

EP 0 615 669 B1